# EUROPEAN PATENT APPLICATION

(11) **EP 2 783 905 A2**
(43) Date of publication of application: **01.10.2014**
(21) Application number: 14161075.8
(22) Date of filing: 21.03.2014
(51) Int. Cl.: B60L 11/18

(54) **Battery monitoring system, battery cartridge, battery package, and ridable machine**

(30) Priority: 29.03.2013 JP 2013073792
(71) Applicant: FUJITSU LIMITED, Kawasaki-shi, Kanagawa 211-8588 (JP); Transtron, Inc., yokohama-shi, Kanagawa 222-0033 (JP)
(72) Inventor: Nakanishi, Masanori, Kanagawa 211-8588 (JP); Tsukada, Kazuyoshi, Kanagawa 222-0033 (JP); Sasaki, Jun, Kanagawa 222-0033 (JP)
(74) Representative: HOFFMANN EITLE

(57) **Abstract**

Provided is a battery monitoring system including a plurality of batteries (213) connected in series, a current/voltage measuring unit (214p) configured to measure an electric current and a voltage of a first battery in response to a measurement instruction, and a plurality of voltage measuring units (214s) configured to measure a voltage of a second battery (213) other than the first battery (213) in response to a measurement instruction. The voltage measuring units (214s) are connected to the current/voltage measuring unit (214p) with a daisy-chain connection by a communication interface, and the current/voltage measuring unit (214p) and the voltage measuring unit (214s) transfer the measurement instruction to another voltage measuring unit (214s) through the daisy-chain connection.

## Description

### FIELD

The embodiments discussed herein are related to a battery monitoring system, a battery cartridge, a battery package, and a ridable machine.

### BACKGROUND

It is the mainstream to use lithium ion batteries (hereinafter, abbreviated to "LiBs") having high energy density as batteries for next generation vehicles such as electric vehicles (EVs) and hybrid electric vehicles (HEVs). However, it is difficult to charge an LiB as quickly as a fueling time (for example, several minutes) of a gasoline-powered vehicle or the like due to reasons such as batter performance degradation control or ensuring safety (for example, heat generation prevention). As a countermeasure, a technique of removing a battery module that needs to be charged and replacing it with a fully charged battery module has been proposed (for example, see U.S. Patent No. 8,164,300).

Meanwhile, it is an important functional requirement to EVs or HEVs to accurately calculate an "electricity mileage" of an EV or an HEV corresponding to a "gas mileage" of gasoline-powered vehicles or the like. For example, the "electricity mileage" is obtained by dividing an integration value (electric energy) of electric power obtained by the product of electric current and voltage by an integration value (moving distance) of a vehicle speed. Thus, for the calculation of the "electricity mileage," the accuracy of monitoring (measuring) of a voltage and an electric current of a battery and simultaneousness of measurement of the voltage and the electric current are required.

### SUMMARY

It is an object of the present invention to improve the accuracy of monitoring (measuring) of a voltage and an electric current of a battery and simultaneousness of measurement of the voltage and the electric current.

A battery monitoring system according to an aspect includes a plurality of batteries connected in series, a current/voltage measuring unit configured to measure an electric current of the plurality of batteries connected in series and a voltage of a first battery among the plurality of batteries in response to a measurement instruction, and a plurality of voltage measuring units configured to measure a voltage of a second battery other than the first battery among the plurality of batteries in response to a measurement instruction, wherein the voltage measuring units are connected to the current/voltage measuring unit with a daisy-chain connection by a communication interface, and the current/voltage measuring unit and the voltage measuring unit transfer the measurement instruction to another voltage measuring unit through the daisy-chain connection.

The accuracy of monitoring (measuring) of a voltage and an electric current of a battery and simultaneousness of measurement of a voltage and an electric current are improved.

### BRIEF DESCRIPTION OF DRAWINGS

FIG. 1 is a block diagram illustrating an exemplary vehicle (ridable machine) according to an embodiment;
FIG. 2 is a block diagram illustrating an exemplary configuration directed to an LiB unit illustrated in FIG. 1;
FIG. 3 is a block diagram illustrating an exemplary configuration directed to a battery package illustrated in FIG. 2;
FIG. 4 is a block diagram illustrating an exemplary configuration of a balance board illustrated in FIG. 3;
FIG. 5 is a sequence diagram illustrating an exemplary voltage/current acquisition operation of a battery monitoring system illustrated in FIGS. 3 and 4;
FIG. 6 is a block diagram illustrating a comparative example of FIG. 4;
FIG. 7 is a sequence diagram illustrating a comparative example of FIG. 5;
FIG. 8 is a block diagram illustrating a comparative example of a vehicle configuration illustrated in FIG. 1;
FIG. 9 is a block diagram illustrating an exemplary vehicle (ridable machine) according to an embodiment;
FIG. 10 is a block diagram illustrating an exemplary vehicle (ridable machine) according to an embodiment;
FIG. 11 is a sequence diagram illustrating an exemplary automatic module recognition process according to an embodiment; and
FIG. 12 is a sequence diagram illustrating an exemplary automatic module recognition process according to another embodiment.

### DESCRIPTION OF EMBODIMENTS

Hereinafter, exemplary embodiments will be described with reference to the appended drawings. Here, the following embodiments are merely exemplary, and are not intended to exclude applications of various modifications or techniques which are not described below. In the drawings used in the following embodiments, the same components are denoted by the same reference numerals unless otherwise set forth.

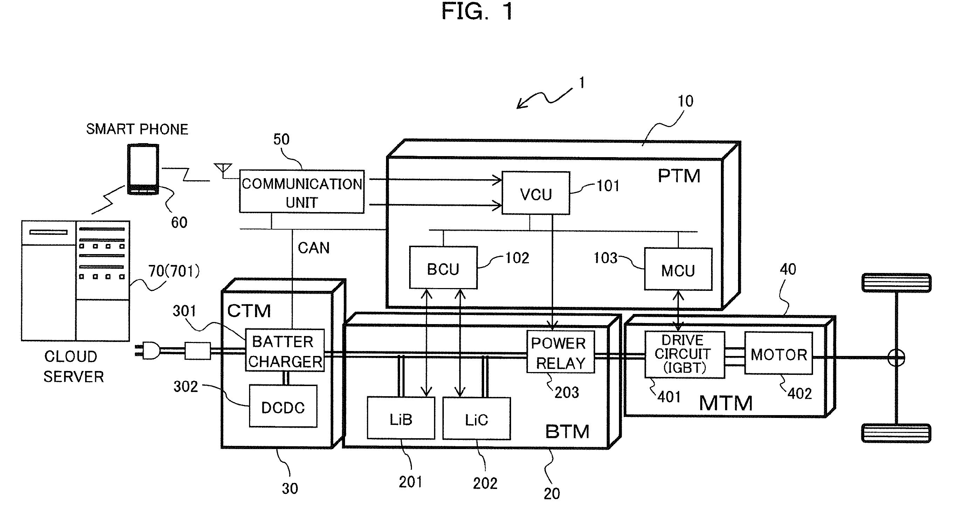

FIG. 1 is a block diagram illustrating an exemplary vehicle (ridable machine) according to an embodiment. A vehicle (ridable machine) 1 illustrated in FIG. 1 is, for example, a next generation electric vehicle such as an EV or an HEV, and includes a power train module (PTM) 10, a battery module (BTM) 20, a converter module (CTM) 30, and a motor train module (MTM) 40.

The PTM 10 is a module that controls a power train of an EV or HEV system. The BTM 20 and the MTM 40 configure an exemplary power system of a vehicle, and the PTM 10 configures an exemplary control system that controls the power system.

The PTM 10 and the BTM 20, and the PTM 10 and the MTM 40 are communicably connected by an individual interface (for example, serial peripheral interface: SPI). The PTM 10 is operable to give a control signal to the BTM 20 and/or the MTM 40 through each interface and to collect information of the BTM 20 and/or the MTM 40.

The BTM 20 is a module configuring a power source (battery) of an EV or HEV system. For example, the BTM 20 includes a lithium ion battery (LiB) unit 201, a lithium ion capacitor (LiC) unit 202, and a power relay 203. The BTM 20 may be appropriately provided with a sensor that senses a voltage, an electric current, a temperature, or the like of the LiB unit 201 or the LiC unit 202.

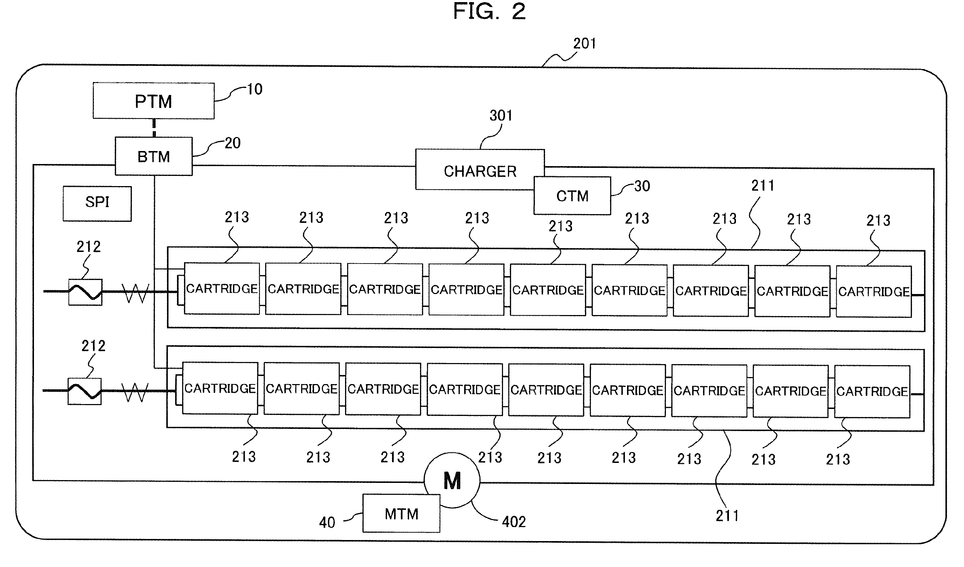

The LiB unit 201 includes one or more battery packages 211 as illustrated in FIG. 2, which will be described later.

The LiC unit 202 is connected in parallel with the LiB unit 201, and supplies an electric current or charges regenerative energy when a load abruptly varies. The LiC unit 202 contributes to increasing the life span of the LiB unit 201. The LiC unit 202 is an option (not an essential component).

The power relay 203 is a relay switch used to supply the MTM 40 with a high voltage of, for example, DC 200 V to 300 V and controlled by the PTM 10. The power relay 203 is connected (controlled ON) when a voltage is normal at the time of activation, and disconnected (controlled OFF) when a voltage is abnormal (electric leakage, an overvoltage, over discharge, or the like).

The MTM 40 is a module that configures a drive system of an EV or an HEV. For example, the MTM 40 includes a drive circuit 401 and a motor 402.

The drive circuit 401 generates a drive voltage (for example, DC 200 V to 300 V) of the motor 402 and supplies the motor 402 with three-phase alternate current (AC) drive power. For example, the drive circuit 401 is configured with a switching element (high voltage element) such as an insulated gate bipolar transistor (IGBT).

The motor 402 is, for example, a three-phase synchronous induction motor and includes a resolver (a rotary angle sensor).

The CTM 30 includes a battery charger 301 and a DC-DC converter (DCDC) 302.

The battery charger 301 supports normal charging compliant with a normal charging standard such asSAE-J1772 and fast charging compliant with a fast charging standard such as CHAdeMO. The battery charger 301 may have a function of returning charging energy of the LiB unit 201 to electric power for home use.

The DC-DC converter 302 generates and supplies electric power (DC 12 V) of auxiliary devices such as an air conditioner and a radio provided for the vehicle. Further, the DC-DC converter 302 generates DC 12 V from a high voltage of DC 200 V to 300 V.

The PTM 10 includes a vehicle control unit (VCU) 101, a battery control unit (BCU) 102, and a motor control unit (MCU) 103.

The VCU 101 is a control unit operable to control traveling of vehicle. The traveling control may include: calculating a drive torque based on an accelerator depression amount; generating a regeneration instruction according to the calculated drive torque; calculating a regenerative energy amount based on a brake depression amount; generating an instruction according to the calculated regenerative energy; controlling drivability.

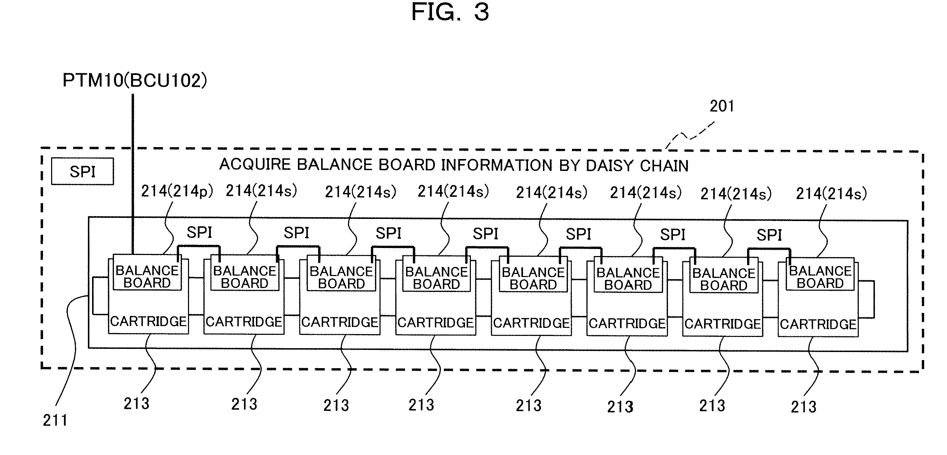

The BCU 102 is a control unit operable to manage and controls the LiB unit 201. This control may include: receiving a voltage, an electric current, and a temperature of a battery cartridge 213 which will be described later with reference to FIGS. 2 and 3; performing safety control; performing voltage balance control between cells 241 in the battery cartridge 213; calculating a used energy amount; calculating a battery level; and estimating a degradation state of the battery cartridge 213.

The MCU 103 is a control unit operable to control a motor and perform feedback control on the motor 402 based on torque instructed from the VCU 101.

The VCU 101, the BCU 102, and the MCU 103 may be integrated into a single module. With the integration, the BTM 20 and the MTM 40 can be modified into a module having no operational processing function implemented by a central processing unit (CPU), a microcomputer, or the like (hereinafter, may be referred to as a "non-intelligent configuration"). Thus, it is easy to functionally change or replace either or both of the BTM 20 and the MTM 40.

As the BTM 20 or the MTM 40 has the non-intelligent configuration, the PTM 10 may be provided with a mechanism of automatically recognizing which of the MTM 40 and the BTM 20 is connected. In this case, when the MTM 40 and/or the BTM 20 are changed or replaced, the PTM 10 is operable to automatically adjust individual characteristics of the MTM 40 or the BTM 20. The details will be described later.

The PTM 10 is operable to appropriately selectively operate the control units 101 to 103, to determine whether the vehicle is a travelable state, to receive an accelerator position when the vehicle is determined to be in the travelable state, and to notify the drive circuit 401 of the MTM 40 of appropriate torque through the MCU 103. The drive circuit 401 is operable to drive the motor 402 as the IGBT is driven according to the torque instructed from the PTM 10.

Further, the PTM 10 is operable to collect information (sensor information) sensed by a sensor (for example, a current sensor and a voltage sensor) installed in the BTM 20 by using the function of the BCU 102. The PTM 10 is operable to calculate and manage, for example, over charging, over discharging, residual capacity, degradation state, and the like of the battery base on the collected sensor information.

A communication unit 50 may be connected to the PTM 10. The communication unit 50 is operable to communicate with an external device (for example, a cloud server 70 or the like) through a mobile terminal 60 such as a mobile telephone, a smart phone, or a tablet terminal or the Internet via wireless and/or wired lines. The cloud server 70 may be equipped with a storage device 701.

The PTM 10 is operable to provide information related to a state (for example, the charging state of the BTM 20 or the like) of the vehicle to the external device through the communication unit 50. Further, the PTM 10 is operable to download update information related to a vehicle setting from the external device and receive information (control information) related to a vehicle operation (for example, pre-air conditioning control or the like).

### (LiB unit 201)

Next, FIG. 2 illustrates an exemplary configuration of the LiB unit 201. For example, the LiB unit 201 illustrated in FIG. 2 includes one or more battery packages 211 and current sensors 212 provided for the respective battery packages 211.

The battery package 211 is connected to the battery charger 301. The current sensor 212 senses an electric current flowing in one battery package 211.

For example, each of the battery packages 211 includes a plurality of battery cartridges 213 (8 battery cartridges in the example of FIG. 2) connected in series. The battery cartridge 213 is configured with, for example, 12 battery cells (hereinafter, referred to simply as "cells"), and the battery cell is configured with, for example, 8 unit cells.

The battery cartridges 213 are removably attached to a storage mechanism (not illustrated) such as a battery rack installed in the vehicle in units of the battery cartridges 213. Thus, it is easy to appropriately add or reduce the battery capacity in units of the battery cartridges 213 according to required battery characteristics according to a vehicle size or the like.

Since it is possible to reduce a battery unit weight (for example, by about 10 kg) by dividing the battery package 211 into a plurality of battery cartridges 213, it is possible to perform a battery replacement work in units of the battery cartridges 213, and it is also easy to handle the battery cartridge 213 for a person. Thus, for example, a large-size facility described in U.S. Patent No. 8,164,300 is not necessary for a battery replacement work.

Further, it is possible to suppress a voltage of the battery cartridge 213 to a low voltage (for example, 50 V or less), and it is unnecessary to support a high-voltage system infrastructure as a charging system (charging stand). As a result, it is possible to reduce an infrastructure cost, and it is possible to promote popularization of EVs.

Further, it is possible to replace only a defective part in units of the battery cartridges 213 in order to solve the problem of the battery package 211 that is caused by the battery cartridge 213, and it is possible to quickly perform replacement and repair and reduce the cost.

For example, the storage mechanism may be provided with a slot to which a slide battery cartridge 213 is removably attached. Thereby, the slide battery cartridge 213 is easily attached to or detached from the storage mechanism.

The slot may be provided with a connection mechanism of electrically connecting the battery cartridge 213 with another battery cartridge 213 and the PTM 10 when the battery cartridge 213 is mounted. The connection may be a wired connection or a wireless connection. Thus, an electric wiring work is unnecessary. The connection mechanism may include an SPI.

Further, a fixing mechanism of mechanically fixing the battery cartridge 213 may be equipped in the slot. The fixing mechanism can prevent the battery cartridge from getting out of (from electrically disconnected from) the slot due to vibration of the vehicle or the like.

Further, the slot (and/or the battery cartridge 213) may be provided with a mechanism or a structure for preventing the battery cartridge 213 from being mounted in the slot in the state in which the positive and negative signs of the battery cartridge 213 are reversed. Further, the slot (and/or the battery cartridge 213) may be provided with a mechanism for preventing invasion of mud or water from the outside.

Each of the battery cartridges 213 includes a current/voltage monitoring unit (hereinafter, referred to as a "balance board") 214 as illustrated in FIG. 3. The balance board (BB) 214 monitors (measures) an electric current and/or voltage of a cell group configuring the battery cartridge 213 in response to a measurement instruction (measurement command). Any one of the balance boards 214 is connected with the PTM 10 (the BCU 102), for example, through the SPI. Hereinafter, the balance board 214 connected with the PTM 10 through the SPI may be referred to as a "primary board 214p".

The balance board 214 (hereinafter, may be referred to as a "secondary board 214s") other than the primary board 214p is connected with the primary board 214p, for example, through the SPI in a daisy chain manner (hereinafter, may be referred to as a daisy-chain connection). The balance boards 214 connected in the daisy chain manner configure an exemplary battery monitoring system.

Through the daisy-chain connection, the control signal (measurement instruction) applied from the PTM 10 (the BCU 102) to the primary board 214p can be sequentially transferred to the secondary board 214s through the SPI. Meanwhile, information (for example, voltage monitoring (measuring) information) obtained by the secondary board 214s can be sequentially transferred to the primary board 214p through the daisy-chain connection. Further, a direction from the primary board 214p to the secondary board 214s at the last stage in the daisy-chain connection may be referred to as "downstream," and an opposite direction thereto may be referred to as "upstream."

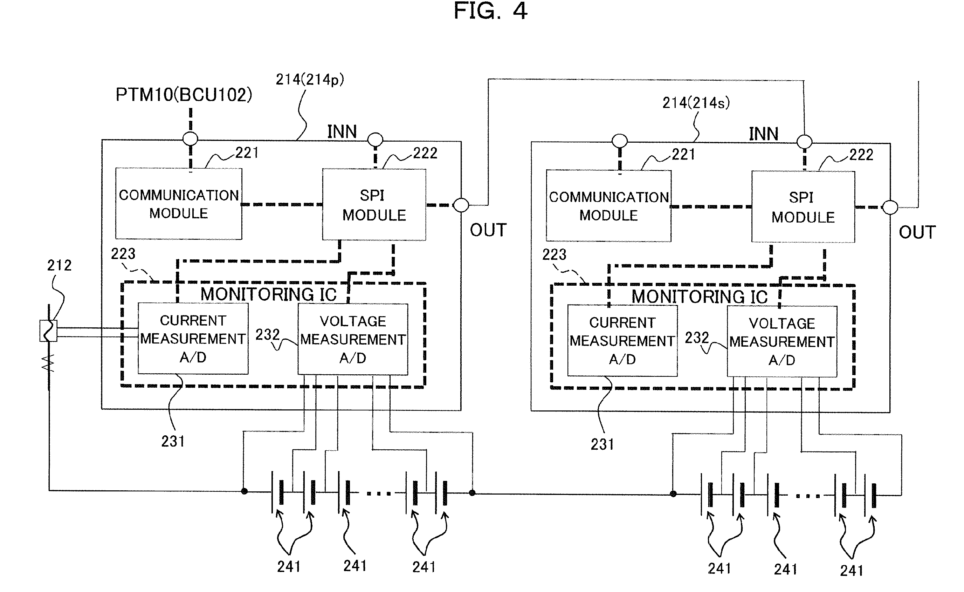

FIG. 4 illustrates an exemplary configuration of the balance board 214. The configuration of the balance board 214 may be common to the primary board 214p and the secondary board 214s. In case where the respective balance boards 214 have a common configuration, the manufacturing cost of the battery cartridge 213 can be reduced. The balance board 214 illustrated in FIG. 4 includes, for example, a communication module 221, an SPI module 222, and a monitoring IC 223.

The communication module 221 is operable to communicate with the PTM 10 (the BCU 102) to receive the control signal from the PTM 10 (the BCU 102). Meanwhile, the communication module 221 is operable to transmit monitoring information (measurement information) obtained by the monitoring IC 223 or monitoring information transferred from another balance board 214 (at the downstream of the daisy-chain connection) to the SPI module 222 to the PTM 10 (the BCU 102).

In addition, the communication module 221 is operable to transfer the received control signal to the monitoring IC 223 or another balance board 214 (at the downstream of the daisy-chain connection) through the SPI module 222. The function of the communication module 221 may be enabled in the primary board 214p but disabled in the secondary board 214s. Thus, the communication module may be unmounted in the secondary board 214s.

The SPI module 222 is an example of a communication interface and is connected with the SPI module 222 of another balance board 214 through the SPI to configure the above-described daisy-chain connection. Further, the SPI module 222 is communicably connected to the monitoring IC 223 and is operable to transfer the monitoring information obtained by the monitoring IC 223 to another balance board 214 (at the upstream of the daisy-chain connection) or transmit the monitoring information to the PTM 10 (the BCU 102) through the communication module 221.

The monitoring IC 223 may include a current measurement analog/digital (A/D) converter 231 and a voltage measurement A/D converter 232. The function of the current measurement A/D converter 231 may be enabled in the primary board 214p but disabled in the secondary board 214s. Thus, the current measurement A/D converter 231 may be unmounted in the secondary board 214s.

In other words, the primary board 214p is an example of a current/voltage measuring unit configured to measure an electric current of batteries connected in series and a voltage of a first battery in response to a measurement instruction. Meanwhile, the secondary board 214s is an example of a voltage measuring unit configured to measure a voltage of a second battery other than the first battery in response to a measurement instruction.

The current measurement A/D converter 231 converts current measurement information of an analog value, which is obtained by a current sensor according to a current measurement instruction transmitted from the SPI module 222 through the communication module 221 of the primary board 214p, into a digital value. The obtained current measurement information is transferred to the communication module 221 through the SPI module 222 and then transmitted to the PTM 10 (the BCU 102).

The voltage measurement A/D converter 232 receives a voltage measurement instruction transferred to each SPI module 222 through the communication module 221 of the primary board 214p, and converts voltage measurement information of an analog value obtained by a voltage sensor into a digital value. The obtained voltage measurement information is transferred to another balance board 214 (at the upstream of the daisy-chain connection) through the SPI module 222 and then transmitted to the PTM 10 (the BCU 102) through the communication module 221.

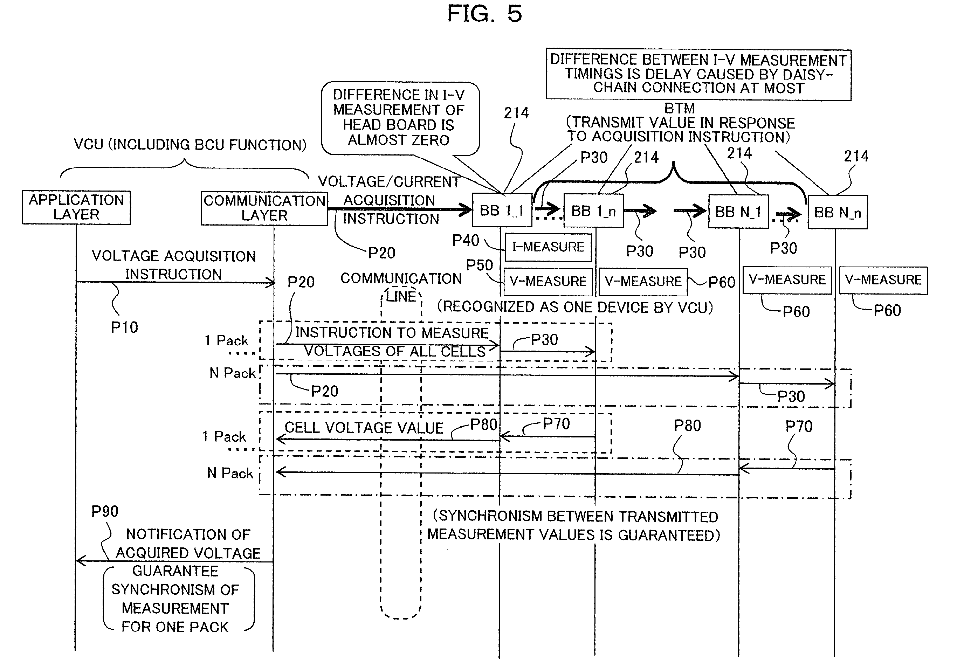

FIG. 5 illustrates an exemplary voltage/current acquisition operation. As illustrated in FIG. 5, when a voltage acquisition instruction is given from an application layer of the PTM 10 (the VCU 101 and the BCU 102) to a communication layer (process P10), the communication layer transmits the same voltage/current acquisition (measurement) instruction (measurement command) to the primary boards 214p in the battery packages 211 (process P20).

The instruction is transferred to the downstream while sequentially passing through the balance boards 214 in the daisy-chain connection through the SPI in each of the battery packages 211 (process P30). The primary board 214p that has received the measurement command starts to measure both of a voltage and an electric current through the monitoring IC 223 (the current measurement A/D converter 231 and the voltage measurement A/D converter 232) (processes P40 and P50), and transmits the measurement result to the PTM 10. Thus, it is possible to make a difference in a measurement timing between a voltage and an electric current in the primary board 214p substantially zero.

Meanwhile, upon receiving the measurement command transferred from the balance board 214 at the upstream side, each of the secondary boards 214s transfers the measurement command to the balance board 214 at the downstream side. Further, the monitoring IC 223 (the voltage measurement A/D converter 232) starts voltage measurement (process P60), and transmits the measurement result to the balance board 214 at the upstream side through the SPI (process P70).

The balance board 214 that has received the voltage measurement result from the balance board 214 at the downstream side further transfers the received voltage measurement result to the balance board 214 at the upstream side. In this way, the voltage measurement results obtained by the monitoring ICs 223 of the respective balance boards 214 are sequentially transferred to the upstream side through the daisy-chain connection by the SPI. Finally, the voltage measurement results are transmitted to (the application layer of) the PTM 10 through the primary board 214p (processes P80 and P90).

Thus, in one battery package 211, a difference between a current measurement timing of each primary board 214p and a voltage measurement timing in each secondary board 214s corresponds to a delay caused by the daisy-chain connection at most. The delay caused by the daisy-chain connection can be made sufficiently small compared to when the measurement command is individually (cyclically) transmitted to each of the balance boards 214. As a result, it is possible to improve synchronism (simultaneousness) of the current measurement result and the voltage measurement result transmitted to the PTM 10, and it is possible to improve the accuracy of the "electricity mileage" calculation.

Further, control for performing a balance adjustment of a voltage difference between the battery cartridges 213 is accurately performed as well. In other words, the PTM 10 can check voltage information being measured by the battery cartridges 213 and having little difference in terms of time, and then the control signal to reduce the voltage difference between the battery cartridges 213 can be sequentially transferred to the secondary board 214s from the PTM 10 (the BCU 102) through the primary board 214p.

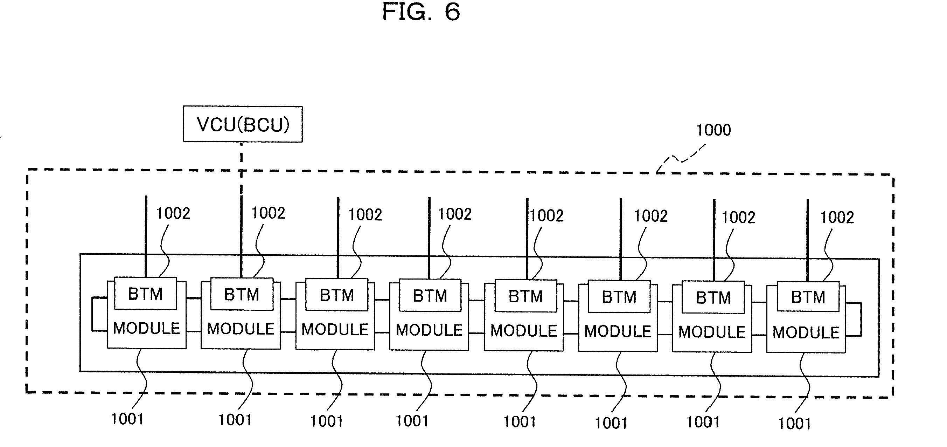

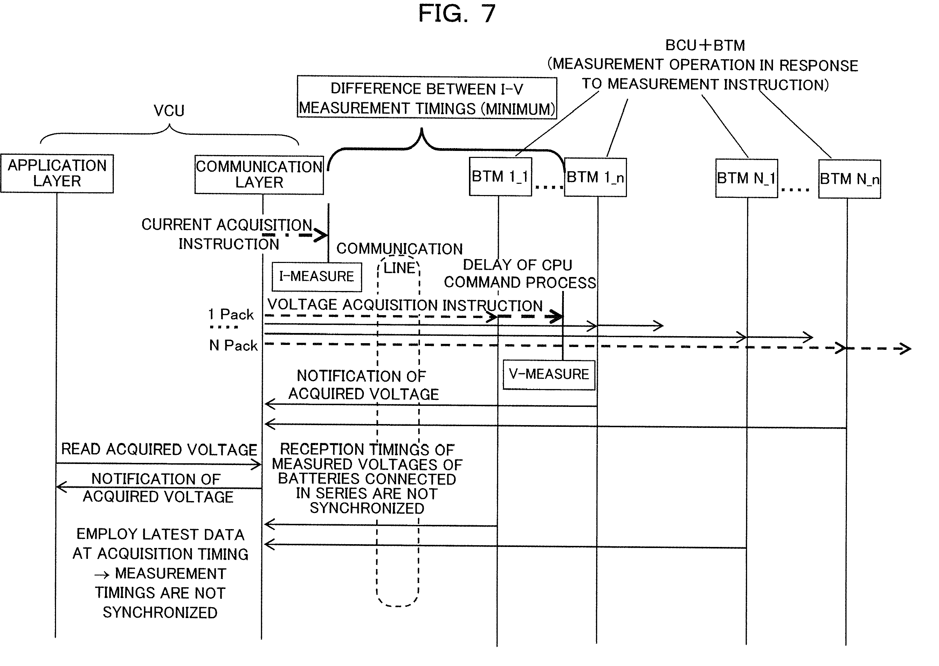

FIGS. 6 and 7 illustrate a comparative example. A battery for an electric vehicle is configured with tens of serial cells, and a voltage and an electric current are measured by a voltage sensor connected to each of the battery cells and a current sensor (usually, one current sensor in a battery system) that is common to all of battery cells.

A plurality of voltage measurement boards (battery management: BTM) are used for voltage measurement due to restrictions (for example, a withstand voltage of a semiconductor device) of a voltage measurement device. In other words, as illustrated in FIG. 6, in a battery package 1000, a battery management 1002 having an operational processing function (the function corresponding to the BCU 102) of the CPU, the microcomputer, or the like is equipped in each of battery modules 1001. Thus, the voltage measurement can be periodically performed at an independent timing of each battery management 1002.

For this reason, as illustrated in FIG. 7, a difference occurs between the current measurement timing and the voltage measurement timing, and simultaneousness of current measurement and voltage measurement is not guaranteed. As a cause of the difference, there are the following factors:
(1) a difference in a transmission timing between the current measurement command and the voltage measurement command from the VCU (BCU);
(2) a command arrival time from the VCU (BCU) to the respective battery managements 1002; and
(3) a processing time until voltage measurement starts (a voltage acquisition instruction is transmitted) after the battery management 1002 receives the command.

Further, a difference in a voltage measurement timing occurs between the battery managements 1002 in one battery package 1000 as well. For this reason, timings at which the VCU (BCU) receives the voltage measurement result from the battery packages 1000 in one battery package 1000 are different from one another.

When information identifying a measurement timing such as a time stamp is allocated to the voltage measurement result, the voltage measurement result at the voltage measurement timing matching the current measurement timing can be used for the calculation "electricity mileage," but in this case, processing is complicated.

As described above, in the comparative example illustrated in FIGS. 6 and 7, since simultaneousness of the current measurement and the voltage measurement is not guaranteed, electric power different from an actual one is obtained as a calculation value, and it appears as an error even in a calculation of impedance that is one of indices used to detect a degradation state of a battery. As a result, it is difficult to accurately calculate the "electricity mileage" and detects the battery state. Further, it would be unavailable to accurately adjust the voltage balance between the balance boards 214.

### (PTM 10)

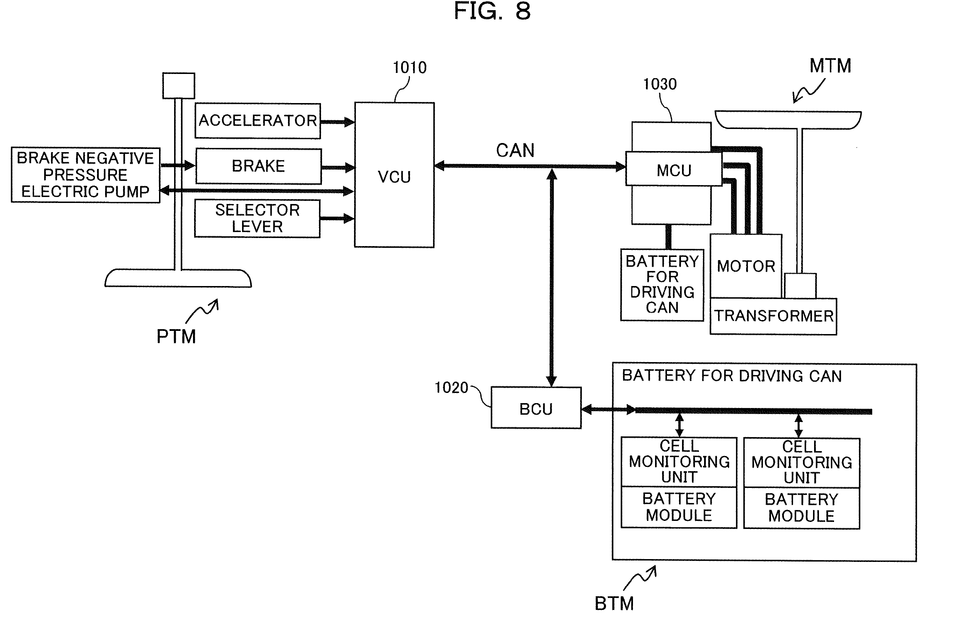

There is a case in which a certain vehicle system such as an EV or an HEV employs a configuration in which three control units of a VCU 1010, a BCU 1020, and an MCU 1030 are distributedly arranged in three modules of a PTM, an MTM, and a BTM as illustrated in FIG. 8. In this case, the three control units 1010, 1020, and 1030 are connected with one another, for example, via a controller area network (CAN) to communicate with one another.

In this configuration, the MCU 1030 is fixedly matched to the MTM, and the BCU 1020 is fixedly matched to the BTM. For this reason, the MTM and the BTM have an unique correspondence relation with the MCU 1030 and the BCU 1020, respectively, and it is difficult to change a motor or a battery. As the battery and the motor are main parts of the electric vehicle, the difficulty of changing these parts leads a degree of freedom as a system to low, and options of a system are small.

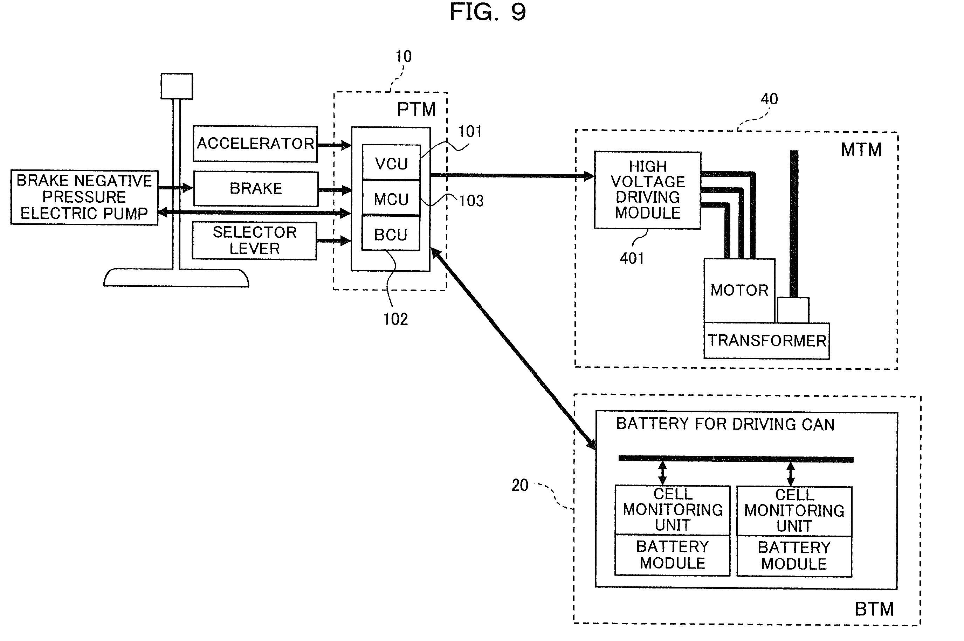

On the other hand, in the PTM 10 according to the present embodiment, the three control units of the VCU 101, the BCU 102, and the MCU 103 are integrated into one control unit as described above with reference to FIG. 1 (see FIG. 9). Thus, there are advantages compared to the configuration in which the three control units are distributedly arranged in terms of a cost, an installation place, and installation easiness.

As the control units are integrated, the BTM 20 and the MTM 40 do not need to have the operational processing function of the CPU, the microcomputer, or the like and can be modified to have a non-intelligent configuration such as a sensor or an actuator. As the BTM 20 or the MTM 40 has the non-intelligent configuration, options of a module connected to the PTM 10 can be diverse.

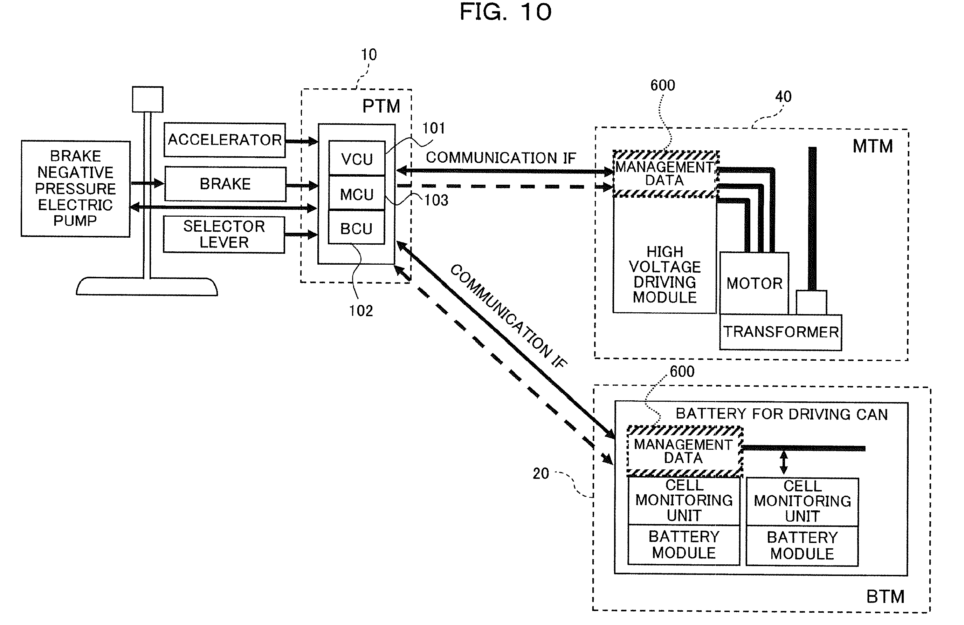

In this regard, the PTM 10 is operable to automatically recognize a module to be connected and eliminate environment setting on the system. The automatic recognition can be performed in the following. Management data is stored in a memory 600 equipped in each of modules 20 and 40, and when the PTM 10 is activated, the PTM 10 reads the management data from the memory 600 through a predetermined communication interface (for example, an SPI) as illustrated in FIG. 10.

The PTM 10 can automatically set characteristic matching with the modules 20 and 40 by automatically recognizing the connected module 20 and/or 40 based on the management data.

Examples of the management data stored in the memory 600 may include an identification code (identification information) of the modules 20 and 40 and data related to individual characteristics, control, diagnosis, and the like of the modules 20 and 40. The management data is an example of parameters unique to the modules 20 and 40 corresponding to the identification codes of the modules 20 and 40.

Examples of the parameter of the MTM 40 may include torque characteristics, speed characteristics, and resolver characteristics. Examples of the parameter of the BTM 20 may include an LiB type, LiB capacity, charging and/or discharging characteristics, temperature characteristics, charging and/or discharging cycle characteristics, self-discharging characteristics, an over charging and/or over discharging detection voltage.

The identification code may be allocated in units of parts that may be replaced. For example, the identification code may be allocated in units of components (the battery and the balance board 214) configuring one battery cartridge 213 or in units of the battery cartridges 213. Further, the identification code may be (comprehensively) allocated in units of the battery module 20. In any of the cases, a parameter corresponding to an identification code is set.

The PTM 10 is operable to automatically recognize a change in the connected module 20 and/or 40 by reading the identification code from the memory 600 when activated. Further, in response to the recognition of the change in the connected module 20 and/or 40, the PTM 10 is operable to read the management data from the memory 600 and automatically perform characteristic matching, control, diagnosis, and the like on the changed modules 20 and/or 40.

For example, when the MTM 40 is changed, the PTM 10 can perform characteristic matching of torque characteristics, speed characteristics, and resolver characteristics of the MCU 103 with respect to the MTM 40 based on the acquired management data. When the BTM 20 is changed, similarly, the PTM 10 can automatically perform characteristic matching on the BTM 20 based on the acquired management data.

Further, in the BTM 20, even when the battery cartridge 213 is replaced, characteristic matching or the like can be automatically performed on the replaced battery cartridge 213 based on the parameter corresponding to the identification code allocated to the battery cartridge 213 as described above.

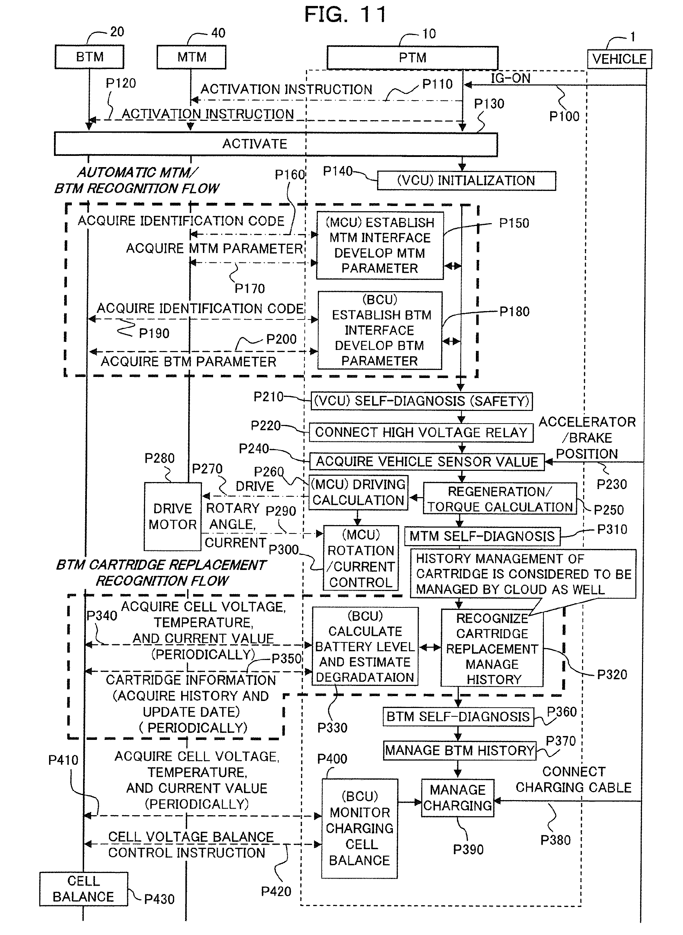

FIG. 11 illustrates an automatic module recognition process flow. As illustrated in FIG. 11, an ignition (IG) of the vehicle 1 is turned on (process P100), the PTM 10 is initially activated, and then the PTM 10 transmits an activation instruction to each of the MTM 40 and the BTM 20 (processes P110 and P120). As a result, the PTM 10, the MTM 40, and the BTM 20 enter the activated state (process P130).

In the activated PTM 10, the VCU 101 is initialized (process P140), and the VCU 101 executes an automatic MTM/BTM recognition flow. For example, the VCU 101 establishes a communication interface with the MTM 40 and the BTM 20, and acquires the identification code of the MTM 40 and the identification code of the BTM 20 from the MTM 40 and the BTM 20 (processes P150, P160, P180, and P190).

When there is a change in the acquired identification code, the PTM 10 (the VCU 101) acquires the management data (parameters) from the changed MTM 40 and/or the BTM 20 (processes P170 and P200). The PTM 10 (the VCU 101) develops the acquired management data to an internal memory or the like (processes P150 and P180). However, there is no change in the acquired identification code, the PTM 10 (the VCU 101) is not required to acquire the management data.

Thereafter, the PTM 10 (the VCU 101) performs self-diagnosis related to safety (process P210), turns on the power relay 203 (see FIG. 1) in response to the confirmation of the safety to electrically connect the BTM 20 with the MTM 40 (process P220).

Then, the PTM 10 (the VCU 101) acquires vehicle sensor information sensed by an accelerator position sensor, a brake position sensor, or the like installed in the vehicle (processes P230 and P240), and performs regeneration and/or torque calculation (process P250). As one form, the torque instruction is generated from a map search using a vehicle speed at the current point in time and strokes of the accelerator position sensor and the brake position sensor as search keys. In addition to generation of torque to accelerate the vehicle, some motors can output an instruction to decelerate the vehicle and recover kinetic energy as electric energy (that is referred to as "regeneration") as well. For switching of acceleration torque and regeneration torque and absolute values thereof, in the form in which torque is generated from a map search, it can be changed by inputting a numerical number to a corresponding map.

The calculation result is transferred to the MCU 103, and the MCU 103 calculates drive control information of the motor 402, and transfers the drive control information to the drive circuit 401 (see FIG. 1). The drive circuit 401 drives the motor 402 according to the drive control information (processes P260 to P280).

As the motor 402 is driven, sensor information is transferred from a resolver sensor, a current sensor, or the like provided for the motor 402 to the MCU 103 (process P290). The MCU 103 performs feedback control of a rotation amount of the motor 402 and an electric current flowing of the motor 402 based on the sensor information (process P300).

Meanwhile, the VCU 101 performs MTM self-diagnosis (process P310), and performs a BTM cartridge replacement recognition flow. In the MTM self-diagnosis, an MTM driving unit has a function of detecting, for example, abnormality of an IGBT connected for MTM control and notifying the VCU 101 of the detected abnormality, and the result is transmitted to the VCU 101 using SPI communication as an MTM self-diagnosis result. Further, in the BTM cartridge replacement recognition flow, the VCU 101 performs calculation of a battery level of the LiB unit 201, degradation estimation of the LiB unit 201, replacement recognition of the battery cartridge 213, history management, and the like in cooperation with the BCU 102 (processes P320 and P330).

The replacement recognition of the battery cartridge 213 may be performed such that an identification code is allocated to each of the battery cartridges 213 (for example, an identification code is stored in a memory provided in the balance board 214), and the BCU 102 reads the identification code. In this case, the PTM 10 (the BCU 102) can manage, for example, compatibility of the battery cartridge 213 removably attached to the slot based on the identification code.

For example, when the battery cartridge 213 that does not satisfy a predetermined performance is mounted in the slot, the PTM 10 (the BCU 102) may display error information representing incompatibility on a monitor installed in the vehicle to give notification to the user. Thus, a vehicle manufacturer can prevent the battery cartridge 213 other than a genuine product from being used.

The BCU 102 periodically acquires a cell voltage, a temperature, a current value, and the like from the BTM 20 (the LiB unit 201) (process P340), and periodically acquires cartridge information (for example, a history, and update date and time) (process P350).

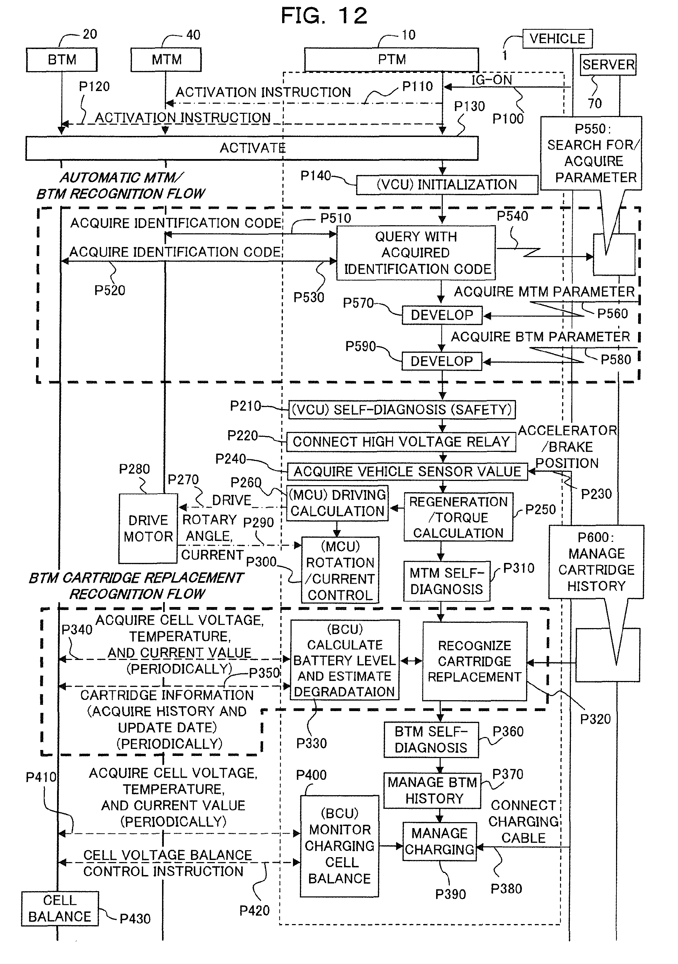

The BCU 102 calculates a battery level of the LiB unit 201 based on the acquired cell voltage, the temperature, the current value, and the like, and estimates the degradation state of the LiB unit 201 based on the cartridge information. The history management of the battery cartridge 213 may be performed in an external device such as the cloud server 70 which will be described later with reference to FIG. 12.

Meanwhile, the VCU 101 performs BTM self-diagnosis and BTM history management (processes P360 and P370). In the "BTM self-diagnosis," it is checked that the command from the BTM 20 is normally transmitted to the replaced battery cartridge 213 and that a normal response to the command can be received from the battery cartridge 213. Subsequently, it is checked whether a voltage of each the battery cell 241 can be acquired, and it is determined whether the value is appropriate based on charging state information obtained by history management which will be described later. Further, it is checked that current measurement is possible at the same time. In the "BTM history management," history information (serial number, assembly date, a total of hours of use, the number of use cycles, a failure history, battery capacity, a current charging state, and the like) of the replaced battery cartridge 213 is acquired, and whether a use history is extremely different from that of the other battery cartridges 213 is checked. Further, whether the charging state between the battery cartridges 213 almost matches is checked. As a result, when there is abnormality, an alarm is generated, or a re-replacement instruction is output.

Further, when a charging cable is connected (process P380), the VCU 101 performs charging management including monitoring the charging state, balance control of a cell voltage, and the like in cooperation with the BCU 102 (processes P390 and P400).

For example, the BCU 102 periodically acquires a cell voltage, a temperature, a current value, and the like from the BTM 20 (the LiB unit 201) (process P410), and gives an instruction to perform balance control of a cell voltage based on the acquired parameters to the BTM 20 (the balance board 214 of the LiB unit 201) (process P420). Through this operation, balance control of a cell voltage is performed so that a voltage difference between the battery cells 241 of the battery cartridge 213 connected in series is eliminated (process P430).

At this time, as described above with reference to FIG. 5, the accuracy of balance control is improved since the balance boards 214 of the respective battery cartridges 213 are connected in the daisy-chain manner. For example, the PTM 10 checks voltage information being measured by the battery cartridges 213 and having little difference in terms of time, and then the control signal to reduce the voltage difference between the battery cartridges 213 can be sequentially transferred to the secondary board 214s from the PTM 10 (the BCU 102) through the primary board 214p.

As described above, as characteristic matching is automatically performed, it is possible to reduce the number of processes required for development when a module is changed.

Further, the management data may be centrally managed, for example, in a storage device that is equipped outside the vehicle and is accessible via a wired or wireless communication line. The PTM 10 may appropriately access the storage device and download the management data from the storage device. For example, the storage device corresponds to the storage device 701 equipped in the cloud server 70 (see FIG. 1).

FIG. 12 illustrates an example thereof (an automatic module recognition process flow according to another embodiment). As illustrated in FIG. 12, an ignition (IG) of the vehicle 1 is turned on (process P100), the PTM 10 is initially activated, and the PTM 10 transmits an activation instruction to each of the MTM 40 and the BTM 20 (processes P110 and P120). As a result, the PTM 10, the MTM 40, and the BTM 20 enter the activated state (process P130).

In the activated PTM 10, the VCU 101 is initialized (process P140), and the VCU 101 executes an automatic MTM/BTM recognition flow. For example, the VCU 101 establishes a communication interface with the MTM 40 and the BTM 20, and acquires the identification code of the MTM 40 and the identification code of the BTM 20 from the MTM 40 and the BTM 20 (processes P510 and P520).

When there is a change in the acquired identification code, the PTM 10 (the VCU 101) transmits the identification code to the cloud server 70 to make an inquiry (process P530). The cloud server 70 searches the management data (parameter) of the MTM 40 and/or the BTM 20 corresponding to the received identification code in the storage device 701 (processes P540 and P550), and transmits the acquired management data (the MTM parameter and/or the BTM parameter) to the vehicle 1 (process P560 and P580).

The transmission may be performed after the cloud server 70 checks whether the vehicle 1 is a registered vehicle based on the identification code received from the vehicle 1 (security authentication) or the like. In the security authentication, the vehicle 1 may be specified, for example, such that the identification code is extended to designate information specifying an article.

The vehicle 1 (the PTM 10) develops the management data received (downloaded) from the cloud server 70 to an internal memory or the like (processes P570 and P590). When there is no change in the acquired identification code, the PTM (the VCU 101) is not required to acquire the management data from the cloud server 70.

Subsequently, the same processes as processes P210 to P430 illustrated in FIG. 11 are performed. Here, in the "BTM cartridge replacement recognition flow" (processes P320 to P350), the history management of the battery cartridge 213 may be performed in the cloud server 70 (process P600).

### (Others)

The battery monitoring system configured with the balance boards 214 connected in the daisy-chain manner may be applied to a vehicle (for example, see FIG. 8) in which the VCU 101, the BCU 102, and the MCU 103 are not integrated into a single module (the PTM 10).

Further, the above embodiment has been described in connection with the example in which the battery monitoring system and the integrated control unit (the PTM 10) are applied to a vehicle (the vehicle 1) such as an EV or an HEV, but the battery monitoring system and the integrated control unit (the PTM 10) may be applied to other ridable machines such as trains or vessels.

According to the above-described technology, it is possible to improve the accuracy of monitoring (measuring) of a voltage and an electric current of a battery and simultaneousness of measurement of the voltage and the electric current.

## Claims

1. A battery monitoring system, comprising:
a plurality of batteries (213) connected in series;
a current/voltage measuring unit (214p) configured to measure an electric current of the plurality of batteries (213) connected in series and a voltage of a first battery among the plurality of batteries (213) in response to a measurement instruction; and
a plurality of voltage measuring units (214s) configured to measure a voltage of a second battery other than the first battery among the plurality of batteries (213) in response to a measurement instruction,
wherein the voltage measuring units (214s) are connected to the current/voltage measuring unit (214p) with a daisy-chain connection by a communication interface (222), and
the current/voltage measuring unit (214p) and the voltage measuring unit (214s) transfer the measurement instruction to another voltage measuring unit (214s) through the daisy-chain connection.

2. The battery monitoring system according to claim 1,
wherein the plurality of batteries (213) configure a battery package (211) that supplies a power system of a ridable machine with electric power, and
the measurement instruction is given from a control system (10) that controls the power system to the current/voltage measuring unit (214s).

3. A battery cartridge, comprising:
a current/voltage measuring unit (231, 232) configured to measure an electric current and a voltage of a battery (213) in response to a measurement instruction; and
a communication interface (222) connected to a voltage measuring unit (232) that measures a voltage of another battery and transfers the measurement instruction to the voltage measuring unit(232).

4. A battery cartridge, comprising:
a voltage measuring unit (232) configured to measure a voltage of a battery (213) in response to a measurement instruction; and
a communication interface (222) connected to another voltage measuring unit (232) that measures a voltage of another battery and transfers the measurement instruction to the other voltage measuring unit(232).

5. A battery package, comprising:
the battery cartridge according to claim 3; and
the battery cartridge according to claim 4.

6. A ridable machine (1), comprising:
a power system comprising a battery module (20) including a plurality of batteries (213) connected in series and a motor module (40) configured to receive electric power from the battery module (20) and generates drive power; and
a control system comprising a control module (10) configured to control the power system,
wherein the battery module (20) comprises a battery monitoring system configured to monitor the plurality of batteries (213),
the battery monitoring system further comprises
a current/voltage measuring unit (214p) configured to measure an electric current and a voltage of a first battery among the plurality of batteries (213) in response to a measurement instruction given from the control module (10), and
a plurality of voltage measuring units (214s) configured to measure a voltage of a second battery other than the first battery among the plurality of batteries (213) in response to a measurement instruction,
wherein the voltage measuring units (214s) are connected to the current/voltage measuring unit (214p) with a daisy-chain connection by a communication interface (222), and
wherein the current/voltage measuring unit (214p) and the voltage measuring unit (214s) transfer the measurement instruction to another voltage measuring unit (214s) through the daisy-chain connection.
